Europäisches Patentamt

European Patent Office

Office européen des brevets

(11) Publication number: **0 252 745**
**A2**

# (12) EUROPEAN PATENT APPLICATION

(21) Application number: 87306090.9

(22) Date of filing: 09.07.87

(51) Int. Cl.⁴: **H 01 J 37/20**
**H 01 J 37/28**

(30) Priority: 11.07.86 JP 164145/86
11.07.86 JP 164146/86
04.12.86 JP 289157/86

(43) Date of publication of application:
13.01.88 Bulletin 88/02

(84) Designated Contracting States: **DE FR GB**

(71) Applicant: **AGENCY OF INDUSTRIAL SCIENCE &
TECHNOLOGY MINISTRY OF INTERNATIONAL TRADE
& INDUSTRY**
3-1 Kasumigaseki 1-chome Chiyoda-ku
Tokyo (JP)

**SEIKO INSTRUMENTS INC.**
31-1, Kameido 6-chome Koto-ku
Tokyo 136 (JP)

(72) Inventor: **Ono, Masatoshi Ministry of Int. Trade and Ind.
Electro Technical-Laboratory 1-4, Umezono 1-chome
Sakura-mura Niihari-gun Ibaragi (JP)**

**Mizutani, Wataru Ministry of Int. Trade and Ind.
Electro Technical-Laboratory 1-4, Umezono 1-chome
Sakura-mura Niihari-gun Ibaragi (JP)**

**Murakami, Hiroshi Ministry of Int. Trade and Ind.
Electro Technical-Laboratory 1-4, Umezono 1-chome
Sakura-mura Niihari-gun Ibaragi (JP)**

**Bando, Hiroshi Ministry of Int. Trade and Ind.
Electro Technical-Laboratory 1-4, Umezono 1-chome
Sakura-mura Niihari-gun Ibaragi (JP)**

**Wakiyama, Shigeru
c/o Seiko Instruments Inc 31-1, Kameido 6-chome
Koto-ku Tokyo (JP)**

**Sakai, Fumiki
c/o Seiko Instruments Inc 31-1, Kameido 6-chome
Koto-ku Tokyo (JP)**

**Wakatsuki, Takashi
c/o Seiko Instruments Inc 31-1, Kameido 6-chome
Koto-ku Tokyo (JP)**

(74) Representative: **Miller, Joseph et al
J. MILLER & CO. Lincoln House 296-302 High Holborn
London WC1V 7JH (GB)**

(54) Relative displacement control apparatus.

(57) A relative displacement control apparatus comprising fixed structure (1,11,17) carrying a stopper (18); arm means (13a,13b) which are pivotally movable with respect to the fixed structure (1,11,17); and movement effecting means (21) for effecting pivotal movement of the arm means (13a,13b) into engagement with the stopper (18) characterised in that the arm means have at least first and second relatively movable portions (13a,13b) of which the first portion (13a) is connected to the fixed structure (1,11,17) about a pivot axis (12) and of which the second portion (13b) is engageable with the stopper (18), the movement effecting means (21) being operable so that, during a first part of its operation, it moves the arm means (13a,13b) as a whole from a position in which the latter is spaced from the stopper (18) to a position in which it engages the stopper (18) and, during a second part of its operation, it effects pivotal movement of the second portion (13b) about the stopper (18) and relative movement of the first and second portions (13a,13b).

Fig.6

**Description**

"RELATIVE DISPLACEMENT CONTROL APPARATUS"

This invention relates to a relative displacement control apparatus and, although the invention is not so restricted, it relates more particularly to apparatus which permits relative displacements between a sample and a detecting means as required e.g. in the operations of an optical instrument, an analyzing instrument and scanning tunneling microscopes.

A relative displacement control apparatus is known comprising fixed structure carrying a stopper or "foot"; arm means which are movable about a pivot with respect to the fixed structure; and movement effecting means for effecting pivotal movement of the arm means into engagement with the stopper or foot. Such an apparatus has been incorporated in a scanning tunneling microscope for permitting relative displacement between a sample and a probe and has been disclosed in J.Vac.Sci. Technol.A.Vol.4, No.3,May/Jun 1986 entitled "A Simplified Scanning Tunneling Microscope for Surface Science Studies". In such a known apparatus, the translational reduction of input movement to output movement is proportional to the ratio of the foot-to-probe distance $\Delta l$ to the foot-to-pivot distance l. In order to obtain a larger translational reduction, in other words, to obtain finer control over the probe to sample distance, the whole arm assembly has had to be made longer. Consequently, this has caused difficulties in increasing the translational reduction of such an apparatus when it is desired to incorporate the apparatus in a smaller measuring instrument.

Therefore it is an object of the present invention to provide an apparatus in which there can be finer and more precise control over a detecting means to sample distance without undesirable lengthening of the arm means.

According to the present invention, there is provided a relative displacement control apparatus comprising fixed structure carrying a stopper; arm means which are pivotally movable with respect to the fixed structure; and movement effecting means for effecting pivotal movement of the arm means into engagement with the stopper characterised in that the arm means have at least first and second relatively movable portions of which the first portion is connected to the fixed structure about a pivot axis and of which the second portion is engageable with the stopper, the movement effecting means being operable so that, during a first part of its operation, it moves the arm means as a whole from a position in which the latter is spaced from the stopper to a position in which it engages the stopper and, during a second part of its operation, it effects pivotal movement of the second portion about the stopper and relative movement of the first and second portions.

Preferably, the apparatus is provided with sample holding means and sample detecting or examining means, one of said means being carried by the fixed structure and the other of said means being carried by the said second portion of the arm means.

The said first and second portions of the arm means are preferably constituted by first and second arms which are connected together by pivot means.

The said other of said means may be carried by the second arm adjacent an end of the latter remote from the pivot means.

Resilient means are preferably provided for urging the first and second arms into alignment with each other.

The movement effecting means preferably engages a part of the first arm.

The distance between the said part of the first arm and the pivot axis is preferably substantially greater than the distance between the pivot means and the pivot axis.

The distance between the stopper and the pivot means is preferably substantially greater than the distance between the said part of the first arm and the pivot axis.

The stopper can preferably be adjusted in both vertical and horizontal directions with respect to the fixed structure.

The movement effecting means may comprise a jack.

The movement effecting means may also comprise piezo-electric drive means which engage the jack, control means being provided such that the said first part of the operation may be effected by the jack, and the said second part of the operation may be effected by the piezo-electric drive means.

Adjustment means may be provided for adjusting the position of the sample detecting or examining means with respect to the member carrying the latter.

The adjustment means may comprise a piezo-electric actuator.

The invention is illustrated, merely by way of example, in the accompanying drawings, in which:-

Fig. 1 shows a side view of a known apparatus incorporated into a tunneling scanning microscope for permitting relative displacements between a sample and a scanning probe;

Fig. 2 illustrates initial pivotal movement of an arm assembly forming part of the apparatus of Fig. 1 when it causes the sample to approach the scanning probe, which we refer to here as the 1st stage movement;

Fig. 3 illustrates movement of the said arm assembly during vertical movement of the latter, which we refer to here as the 2nd stage movement;

Fig. 4 illustrates movement of the said arm assembly during a fine approach which takes place after contact between the sample and a foot has been established, which we refer to here as the 3rd stage movement;

Fig. 5 illustrates the translational reduction of the motion of the arm assembly to displacement between the sample and the scanning probe;

Fig. 6 shows the side view of an embodiment of an apparatus according to the present invention incorporated in a tunneling scanning microscope which permits relative displacement between the sample and scanning probe;

Fig. 7 is a plan view of an arm assembly forming part of the apparatus in Fig. 6;

Fig. 8 illustrates a first stage movement of the arm assembly and other related parts of the apparatus of Fig. 6 during which the arm assembly pivots about a pin joint means carried by a main support during coarse approach of the arm assembly to a rigid arm of the apparatus;

Fig. 9 illustrates a position of the arm assembly when a contact point on the arm assembly establishes contact with a foot of the apparatus;

Fig. 10 illustrates a second stage movement of the arm assembly after the said contact has occurred and while fine approach is performed between the scanning probe and the sample;

Fig. 11 illustrates the translational reduction of the motion of a jack to the displacement between the scanning probe and the sample;

Fig. 12 is a side view of another embodiment of the present invention;

Fig. 13 shows a side view of still another embodiment of the present invention;

Fig. 14 is a plan view of the arm assembly of the apparatus of Fig. 13;

Fig. 15 illustrates the first stage movement of the arm assembly and other related parts of the apparatus of Fig. 13;

Fig. 16 illustrates a position of the arm assembly of the apparatus of Fig. 13 when a contact point on the arm assembly thereof establishes contact with a foot thereof;

Fig. 17 illustrates the second stage movement of the apparatus of Fig. 13 while fine approach is performed between the scanning probe and the sample after the said contact has been established;

Fig. 18 is a side view of an alternative design of the apparatus of Fig. 13:

Fig. 19 is a side view of a further embodiment of the invention;

Fig. 20 is a plan view of an arm assembly forming part of the apparatus of Fig. 19;

Fig. 21 illustrates the first stage movement of the arm assembly and other related parts of the aparatus of Fig. 19;

Fig. 22 illustrates a position of the arm assembly of the apparatus of Fig. 19 when a contact point on the arm assembly establishes contact with the foot of the apparatus;

Fig. 23 illustrates the second stage movement of the apparatus of Fig. 19 while fine approach is performed between the scanning probe and the sample after the said contact has been established; and

Fig. 24 is a side view of an alternative design of the apparatus of Fig. 19.

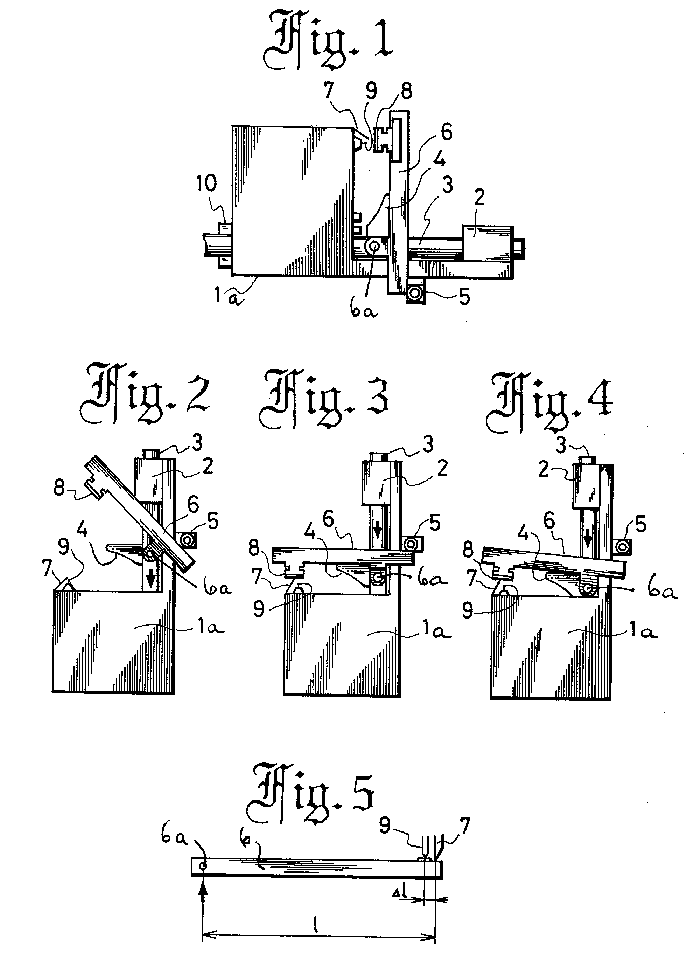

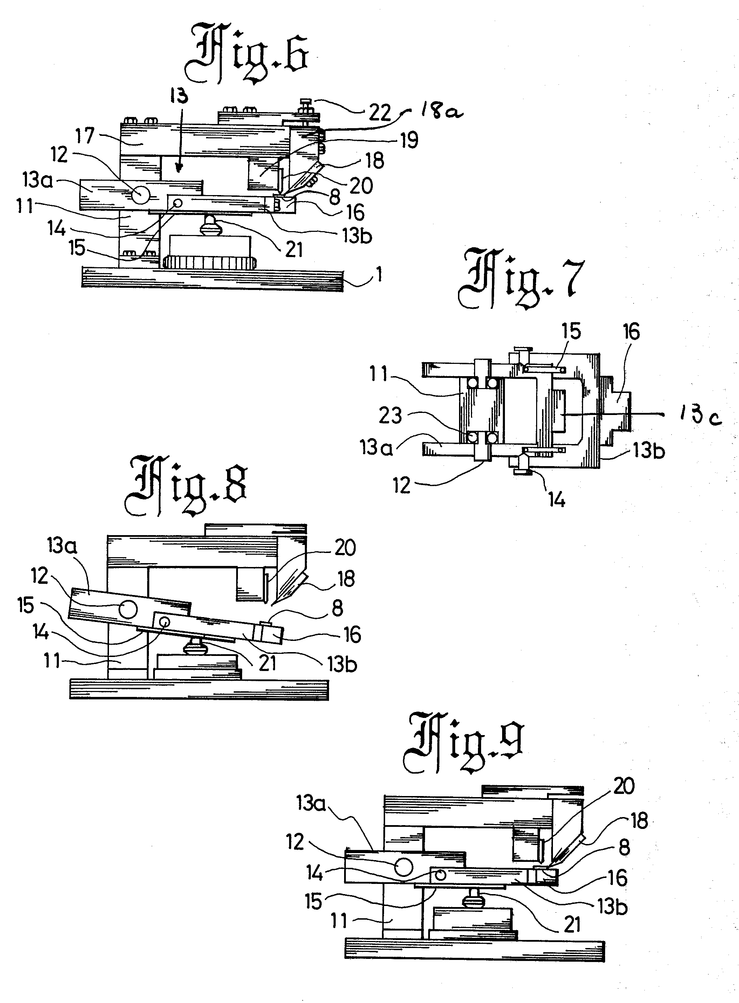

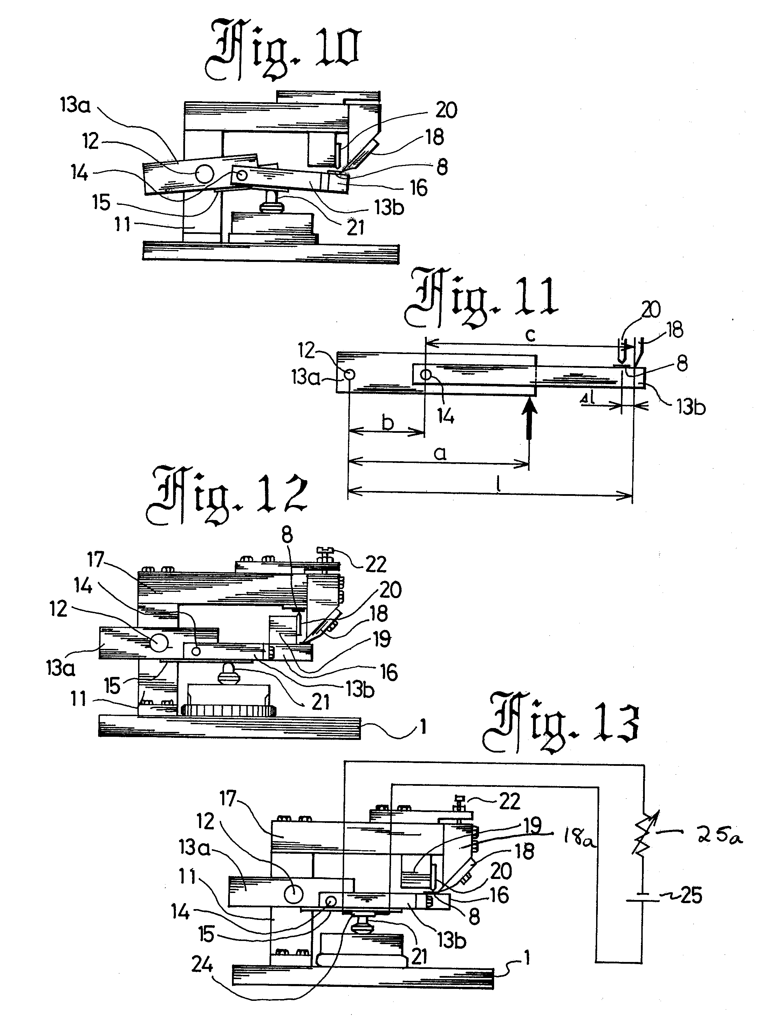

In Fig. 1 there is shown a known tunneling scanning microscope which incorporates apparatus comprising a base 1a in which are slidably mounted two rods 3 which are supported in respective journal bearings 2. Pivotally secured to the rods 3 at a pivot axis 6a is an arm 6 which is provided with means for carrying a sample 8. The rods 3 may be moved by a screw jack 10 in the direction of the arrow so as to allow the arm 6, under the control of a stop 5, to pivot from a position shown in Fig. 2, in which the sample 8 is spaced from a foot or stopper 7 carried by the base 1a, to a position shown in Fig. 3 in which there is contact between the sample 8 and the stopper 7 and between the arm 6 and a stopper 4 carried by the rods 3. In the Fig. 3 position the sample 8 is disposed relatively close to a scanning probe 9.

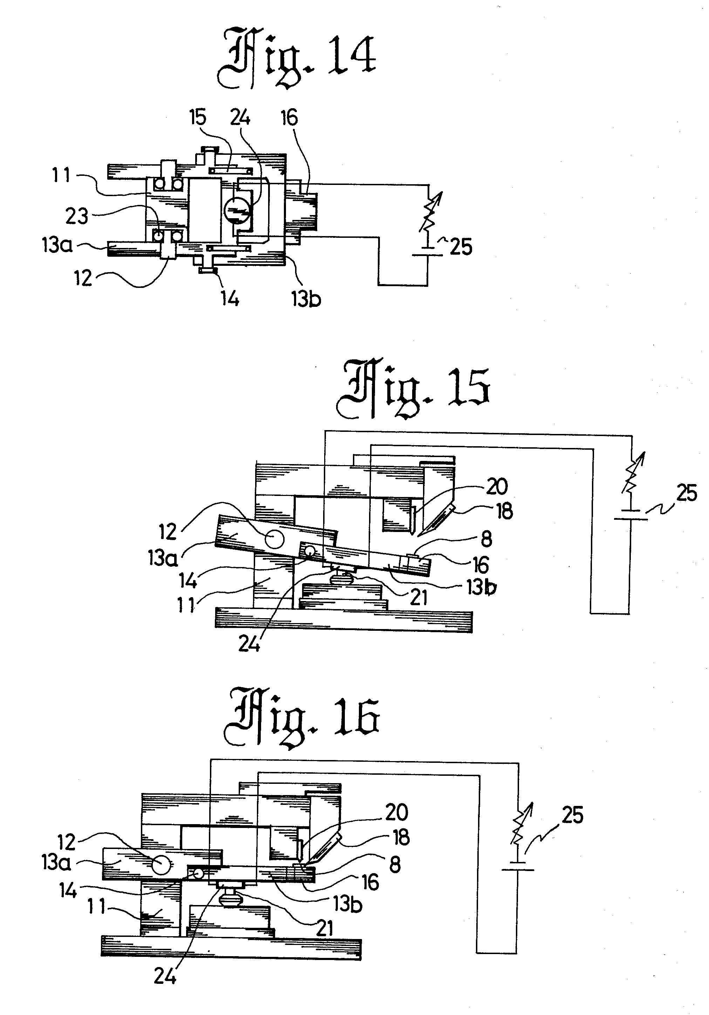

Further movement of the rods 3 in the direction of the arrow causes the arm 6 to pivot to the position shown in Fig. 4, using the end of the stopper 7 as a fulcrum.

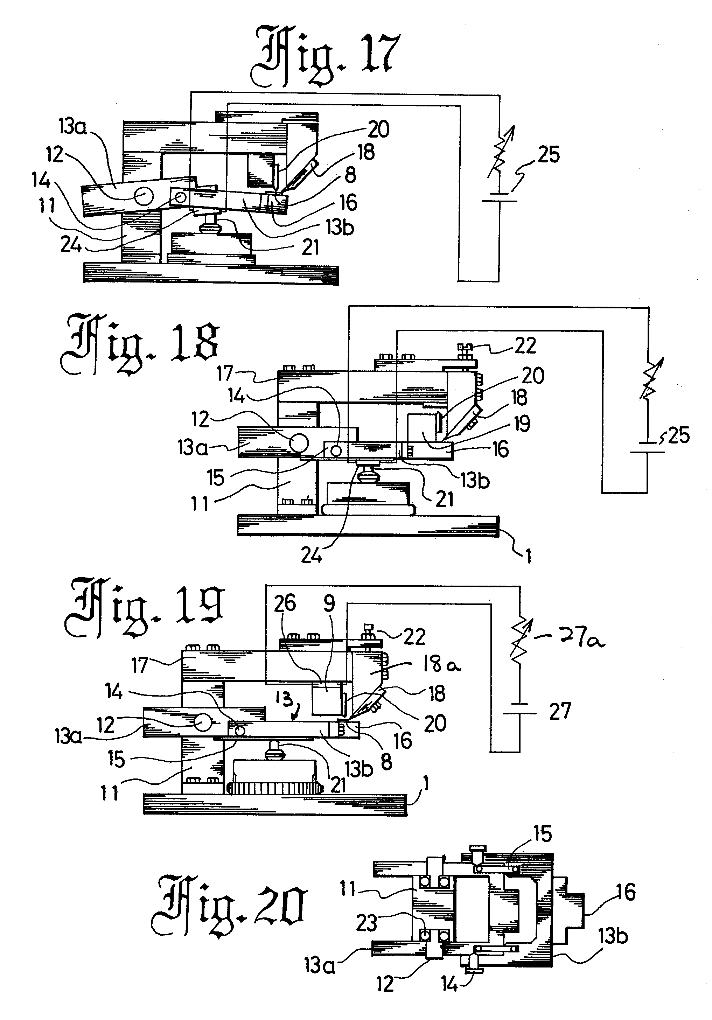

Movement of the sample 8 from the Fig. 3 to the Fig. 4 position effects fine adjustment of the distance between the sample 8 and the scanning probe 9. As will be appreciated, the extent to which the sample 8 moves with respect to the scanning probe 9 as a result of a predetermined amount of movement of the rods 3 is substantially reduced once contact occurs between the sample 8 and the stopper 7. Thereafter the movement of the sample 8 is reduced to $\Delta l/l$ of its previous value, where l is the distance of the stopper 7 from the pivot axis 6a, and $\Delta l$ is the distance between the stopper 7 and the scanning probe 9 (see Fig. 5).

Accordingly, in the construction shown in Figs. 1-4, the only way in which the ratio $\Delta l/l$ can be reduced so as to permit a finer degree of adjustment of the position of the sample 8 with respect to the scanning probe 9 is to increase the length of the arm 6, which is not practicable if the apparatus is required to be small.

There will now, therefore, be described various embodiments of apparatus according to the present invention in which the above-mentioned problem is overcome.

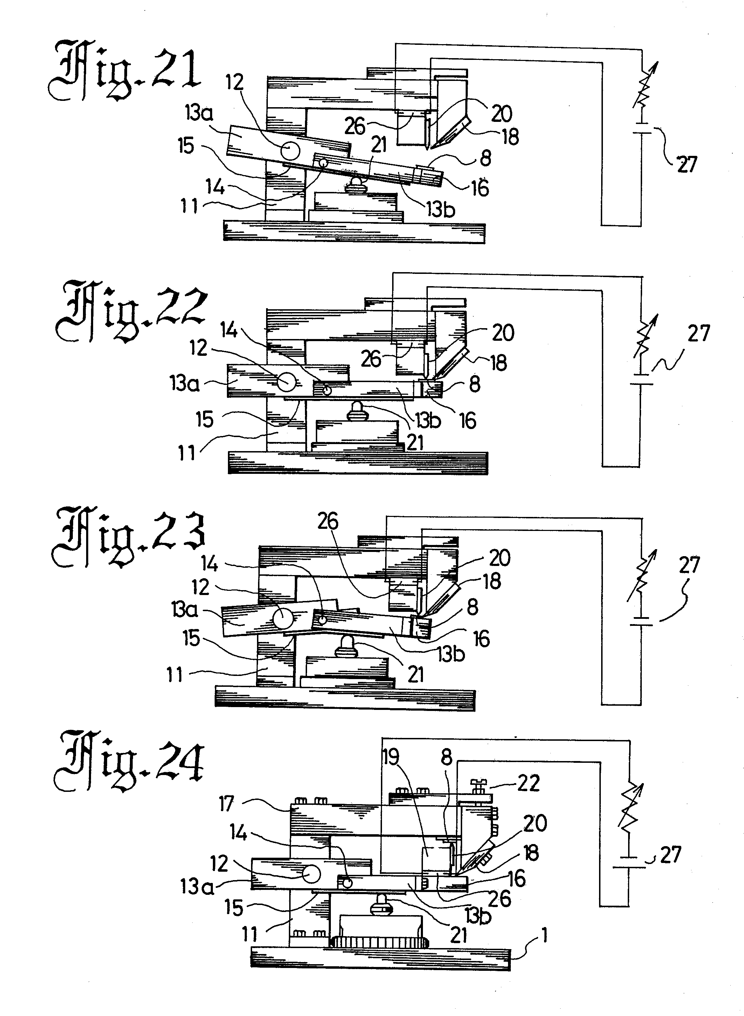

One of the preferred embodiments of the invention which is incorporated into a tunneling scanning microscope for permitting relative displacements between a sample and a scanning means is now described in detail with reference to Figs. 6 to 11 of the accompanying drawings.

Fig. 6 and Fig. 7 show a base 1 and a main support 11 firmly secured thereto, and a flexible arm assembly 13 pivotally held by a pin joint means or dowel pin 12 which is mounted in a plurality of bearings 23 arranged in the main support 11. The arm assembly consists of two arm members, namely a first arm member 13a and a second arm member 13b, which are connected together at a pivot means 14, and a plurality of leaf springs 15 which impose a load on the two arm members 13a, 13b and urge them towards a position, as shown in Fig. 6, in which they are aligned with each other. The second arm member 13b is free to pivot about the axis of the pivot means 14. As will be seen from Fig. 7, each of the arms 13a, 13b is U-shaped in plan, the arm 13a having a projection 13c which is engaged by a jack means 21. The limbs of the arm 13b carry a pair of pivots which constitute the pivot means 14 and which pivotally engage the limbs of the arm 13a. A sample holder 16 is mounted adjacent to the free end of the second arm 13b, and a sample 8 is shown as being fixed to the sample holder 16.

A rigid stationary arm 17 is firmly fixed at the top of the main support 11, the flexible arm assembly 13 being disposed opposite to the rigid arm 17. A "foot" or stopper 18 is attached to a foot holder 18a which is mounted on the rigid arm 17, the foot 18 being disposed opposite to the flexible arm assembly 13. Fine adjustment of the foot 18, both horizontally over the arm assembly 13 and also vertically, is possible by a foot location adjusting means 22. A fine pointed scanning tip 20 is mounted on a scanning tip 3-D actuator means 19 which is firmly attached to the rigid arm 17 at a place adjacent to the foot 18.

The jack means 21 is rigidly mounted on the base 1 for applying motion to a point on the projection 13c of the arm member 13a, which we refer to here as the first point of load. Movements of the components in this embodiment are illustrated in Fig. 8, Fig. 9, Fig. 10 and Fig. 11.

When the arm members 13a and 13b are pushed upwardly from their lowest position (see Fig. 8) by the jack means 21, the arm members 13a and 13b pivot counter-clockwise about the pin joint means or dowel pin 12 by means of which the arm member 13a is mounted on the main support 11, the pin joint means 12 being mounted on the main support 11 by way of the bearings 23. This counter-clockwise pivotal movement of the arm members 13a and 13b continues until contact between the sample 8 and foot 18 is eventually established, as shown in Fig. 9. After the said contact has been established, the motion of the jack means 21 which is applied at a point on the projection 13c of the arm member 13a is reduced, so far as its application to the arm 13b is concerned, through a double-lever-action of the arm members 13a, 13b so that there can be fine displacement between the scanning tip 20 and the sample 8. First, the motion of the jack means 21 is reduced by a first lever action to the ratio of "b" to "a", "b" being the distance between the axis of the pin joint 12 and the axis of the pivot means 14 which we refer to here as the first working point; and "a" being the distance between the axis of the pin joint means 12 and a point on the projection 13c of the arm 13a which we refer to here as the first point of load on the first arm member 13a at which the jack means 21 applies motion thereto. The distances a, b are shown in Fig. 11 which is, however, a purely diagrammatic drawing. Secondly, this reduced motion is further reduced by a second lever action of the second arm member 13b which has a point of load at the place in common with the first working point which we refer to here as the second point of load, and which pivots about the foot 18. The foot-to-scanning tip separation of $\Delta l$ (Fig. 11) and the distance c between the axis of the pivot means 14 and the foot 18, give a translational reduction of $\Delta l/c$. Therefore, the double-lever-action gives a total translational reduction of $(b/a) \times (\Delta l/c)$. In this embodiment, the measurements of a, b, c, and $\Delta l$ are set at 25mm, 10mm, 40mm, and 1mm respectively. This set of measurements thus gives a translational reduction of 100 to 1.

While a prior apparatus having the same arm length as the embodiment of Figs. 6 to 11 only gives a translational reduction of 50 to 1, the embodiment of Figs. 6 to 11 achieves double this translational reduction.

An alternative design is shown in Fig. 12 as having inverted positions between the sample 8 and the scanning tip 20. The design of Fig. 12, however, provides the same translational reduction and same precise and fine control over the scanning tip-to-sample distance as in the embodiment of Figs. 6 to 11.

Figs. 13 to 17 show another embodiment of the present invention having a piezo-electric drive means 24 placed on top of the jack means 21 for providing more precise vibration-free control over the fine approach between the sample 8 and the scanning tip 20. When the fine approach is performed between the sample 8 and the scanning tip 20, the piezo-electric drive means 24 placed on top of the jack means 21 is actuated so as to produce extremely fine motion at the first point of load, thus providing precise and minute control over the scanning tip to sample distance.

Fig. 13 and Fig. 14 show a base 1 and a main support 11 firmly secured thereto and an arm assembly 13 pivotally held by a pin joint means 12 which is mounted in a plurality of bearings 23 arranged in the main support 11. The arm assembly 13 consists of two arm members, i.e. a first arm member 13a and a second arm member 13b, a pivot means 14 connecting the first arm member 13a and the second arm member 13b together, and a plurality of leaf springs 15 such that the two arm members 13a,13b are spring-loaded thereby. The first and second arm members, 13a and 13b, are free to pivot about the pivot means 14. A sample holder 16 is mounted adjacent to the free end of the second arm 13b, and a sample 8 is shown as being fixed to the sample holder 16. At a point at which motion can be imparted to the arm assembly 13 by a jack means 21, the piezo-electric drive means 24 which is connected to a control power source 25 and a control member 25a, is placed on top of the jack means 21. A rigid arm 17 is firmly fixed at the top of the main support 11, and a foot 18 is attached to a foot holder 18a mounted on the rigid arm 17. The foot 18 can be finely adjusted horizontally along the arm assembly and vertically. A fine pointed scanning tip 20 is mounted on a scanning tip fine drive means 19 which is firmly attached to the rigid arm 17 at a place adjacent to the foot 18. The jack means 21 is firmly mounted on the base 1 for providing motion to a point of load in the arm assembly 13 which we refer to here as the first point of load.

Movements of the components in this embodiment are indicated in Fig. 15, Fig. 16 and Fig. 17. When the arm members 13a and 13b are pushed upwardly from their lowest position (see Fig. 15) by the jack means 21, the arm assembly 13 pivots counter-clockwise as a whole about the dowel pin 12 (which we refer to here as the first pivot) secured to the main support 11. This counter-clockwise pivotal motion of the arm members 13a and 13b continues until contact between the sample 8 and the foot 18 is eventually established as shown in Fig. 16. After the contact between the sample 8 and the foot 18 has been established, the motion of the jack means 21 at the first point of load on the arm member 13a is reduced, so far as its application to the arm member 13b is concerned, through a double-lever-action to fine displacement between the scanning tip 20 and the sample 8 in the manner previously described with reference to the accompanying Figs. 6 to 11. Motion at the first point of load during rather large pivoting of the arm 13, i.e. coarse approach, is provided by the jack means 21. When the distance between the sample 8 and the scanning tip 20 is required to be controlled finely and precisely, motion at the first point of load is produced by energizing the piezo-electric drive means 24 which is mounted on the arm member 13b and contacts the jack means 21. In this embodiment, a multilayer piezo-actuator (a multilayer PZT actuator) of 10mm in diameter and 5mm thick may be used as the piezo-electric drive means. The amount of displacement of the multilayer piezo-actuator can be controlled precisely and finely in proportion to the magnitude of the voltage applied thereto. Displacement of the multilayer piezo-actuator is reduced to the ratio of 100 to 1 in the case of this embodiment.

An alternative design is shown in Fig. 18 which is generally similar to that of Figs. 13 to 17. The design of Fig. 18 has inverted positions between the sample 8 and the scanning tip 20 but nevertheless produces the same translational reduction and fine and precise control over the sample to scanning tip distance.

In Figs. 19 to 23 there is shown another embodiment of the present invention having a multilayer piezo-electric actuator 26 placed between a scanning tip 3-D actuator means 19 and a rigid arm 17 for providing precise minute displacement during the fine approach between the sample 8 and the fine pointed scanning tip 20.

Fig. 19 and Fig. 20 show a base 1 and a main support 11 firmly fixed thereto and an arm assembly 13 pivotally held by a pin joint means 12 which is mounted in a plurality of bearings 23 arranged in the main support 11. The arm assembly 13 consists of two arm members, 13a and 13b, which are spring-loaded by a plurality of leaf springs 15 at the joint and pivot about a pivot means 14 in one direction. A sample holder 16 is mounted adjacent to the free end of the arm member 13b, and a sample 8 is shown as being fixed to the sample holder 16. After coarse pivotal movement by the jack means 21 of the arm members 13a and 13b, precise and fine approach of the sample to scanning tip in the Z direction is performed by means of a multilayer piezo-electric actuator 26 placed between the rigid arm 17 and the scanning tip 3-D actuator means 19. The actuator 26 is disposed in a circuit comprising a power source 27 and control 27a. The rigid arm 17 is firmly fixed on top of the main support 11, and a foot 18 is attached to a foot holder 18a mounted on the rigid arm 17. The foot 18 can be finely adjusted horizontally over the arm assembly and vertically. The fine pointed scanning tip 20 is secured to the scanning tip 3-D actuator means 19 which is itself firmly attached to the rigid arm 17 in close proximity to the foot 18. A jack means 21 is firmly fixed on the base 1 for applying motion to the arm assembly 13.

Movements of the components in this embodiment are indicated in Fig. 21, Fig. 22 and Fig. 23. As the arm members 13a and 13b are pushed upwardly by the jack means 21 from their lowest position, the arm members 13a and 13b pivot counter-clockwise about the axis of the pin joint means 12 mounted on the main support 11, and this pivotal movement continues until the sample 8 eventually establishes contact with the foot 18. After the contact between the sample 8 and the foot 18 has been established, the motion applied to the first point of load on the arm 13a is reduced through a double lever action to a fine displacement between the scanning tip 20 and the sample 8 in the manner previously described with reference to the accompanying Figs. 6-11. The motions of the arm assembly during the coarse pivotal movement, and the approach of the sample to the scanning tip are effected by the jack means 21. When displacements between the sample 8 and the scanning tip 20 are required to be controlled minutely and precisely, motion to be applied to the first point of load is produced by energizing the multilayer piezo-electric actuator 26 which is placed between the rigid arm 17 and the scanning tip 3-D actuator means 19. In this embodiment, a multilayer piezo actuator of 10 mm in diameter and 5mm thick may be used.

An alternative design is shown in Fig. 24 which is generally similar to that of Figs. 19-23. The design of Fig. 24 has inverted positions between the sample 8 and the scanning tip 20 but nevertheless produces the same translational reduction and same fine and precise control over the sample to scanning tip distance.

From the foregoing it is apparent that by providing an apparatus having such configurations as described hereinabove, the translational reduction of motions applied to the said reduced displacement can be substantially improved without having to extend the length of the arm assembly. During the fine approach of the sample to the scanning tip, displacements applied at the point of load in the arm assembly may be controlled by a piezo-electric drive means whereby displacements can be controlled to the order of Angstroms. Further, as these displacements produced by the piezo-electric drive means are doubly reduced by means of the said double-lever-action, extremely fine and precise and vibration-free control over the relative positions between two points, e.g., a sample and a scanning tip, becomes possible.

**Claims**

1. A relative displacement control apparatus comprising fixed structure (1,11,17) carrying a stopper (18); arm means (13a,13b) which are pivotally movable with respect to the fixed structure (1,11,17); and movement effecting means (21) for effecting pivotal movement of the arm means (13a,13b) into engagement with the stopper (18) characterised in that the arm means have at least first and second relatively movable portions (13a,13b) of which the first portion (13a) is connected to the fixed structure (1,11,17) about a pivot axis (12) and of which the second portion (13b) is engageable with the stopper (18), the movement effecting means (21) being operable so that, during a first part of its operation, it moves the arm means (13a,13b) as a whole from a position in which the latter is spaced from the stopper (18) to a position in which it engages the stopper (18) and, during a second part of its operation, it effects pivotal movement of the second portion (13b) about the stopper (18) and relative movement of the first and second portions (13a,13b).

2. Apparatus as claimed in claim 1 characterised in that the apparatus is provided with sample holding means (16) and sample detecting or examining means (20), one of said means (16,20) being carried by the fixed structure (1,11,17) and the other of said means (16,20) being carried by the said second portion (13b) of the arm means (13a,13b).

3. Apparatus as claimed in claim 1 or 2 characterised in that the said first and second portions (13a,13b) of the arm means are constituted by first and second arms (13a,13b) which are connected together by pivot means (14).

4. Apparatus as claimed in claim 3 when dependent upon claim 2 characterised in that the said other of said means (16,20) is carried by the second arm (13b) adjacent an end of the latter remote from the pivot means (14).

5. Apparatus as claimed in claim 3 or 4 characterised in that resilient means (15) are provided for urging the first and second arms (13a,13b) into alignment with each other.

6. Apparatus as claimed in any of claims 3 to 5 characterised in that the movement effecting means (21) engages a part (13c) of the first arm (13a).

7. Apparatus as claimed in any of claims 3 to 6 characterised in that the distance (a) between the said part (13c) of the first arm (13a) and the pivot axis (12) is substantially greater than the distance (b) between the pivot means (14) and the pivot axis (12).

8. Apparatus as claimed in any of claims 3 to 7 characterised in that the distance (c) between the stopper (18) and the pivot means (14) is substantially greater than the distance (a) between the said part (13c) of the first arm (13a) and the pivot axis (12).

9. Apparatus as claimed in any preceding claim characterised in that the stopper (18) can be adjusted in both vertical and horizontal directions with respect to the fixed structure (1,11,17).

10. Apparatus as claimed in any preceding claim characterised in that the movement effecting means comprises a jack (21).

11. Apparatus as claimed in claim 10 characterised in that the movement effecting means comprises piezo-electric drive means (24) which engage the jack (21), control means (25a) being provided such that the said first part of the operation may be effected by the jack (21) and the said second part of the operation may be effected by the piezo-electric drive means (24).

12. Apparatus as claimed in claim 2 or in any claim appendant thereto characterised in that adjustment means (19,26) are provided for adjusting the position of the sample detecting or examining means (20) with respect to the member (17 or 13) carrying the latter.

13. Apparatus as claimed in claim 12 characterised in that the adjustment means (19,26) comprises a piezo-electric actuator (26).

14. A relative displacement control apparatus comprising a stationary means (17), a pivotally held flexible arm means (13) oppositely disposed to said stationary means (17), a foot (18) oppositely disposed to said flexible arm means (13), and a jack means (21) for moving said arm means (13) wherein said arm means (13) is relatively moved with respect to said stationary means (17) by motions of said jack means (21) for providing displacements between said arm means (13) and said stationary means (17) through combined actions created by said flexible arm (13) and said foot (18).

0252745

Fig. 1

Fig. 2  Fig. 3  Fig. 4

Fig. 5

Fig. 6

Fig. 7

Fig. 8

Fig. 9

Fig. 10

Fig. 11

Fig. 12

Fig. 13

0252745

# Fig. 14

# Fig. 15

# Fig. 16

Fig. 17

Fig. 18

Fig. 19

Fig. 20

# Fig. 21

12
13a
15
14
11
26
21
8
16
13b
20
18
27

# Fig. 22

14
12
13a
15
11
26
13b
21
20
18
8
16
27

# Fig. 23

26
14
12
13a
15
11
20
18
8
16
13b
21
27

# Fig. 24

17
14
12
13a
15
11
19
8
22
20
18
16
26
13b
21
1
27